# EUROPEAN PATENT APPLICATION

(11) **EP 3 211 660 A1**
(43) Date of publication of application: **30.08.2017**
(21) Application number: 16156988.4
(22) Date of filing: 23.02.2016
(51) Int. Cl.: H01L 21/20

(54) **METHODS AND APPARATUS FOR THIN FILM MANIPULATION**

(71) Applicant: Nokia Technologies Oy, 02610 Espoo (FI)
(72) Inventor: Radivojevic, Zoran, Cambridge CB3 0NP (GB); Liu, Yinglin, Cambridge CB1 3SA (GB); Bower, Chris, Ely CB6 3EN (GB); Bottomley, Joseph, Fenstanton, Cambridgeshire PE28 9HU (GB); Rushton, Ashley, Royston, Hertfordshire SG8 7QT (GB)
(74) Representative: Potter Clarkson LLP

(57) **Abstract**

A thin film manipulation method comprising: wetting a textured surface of a thin film manipulator with a liquid, the textured surface comprising peaks separated by valleys, the liquid forming capillary bridges between the peaks of the textured surface; picking up a thin film by contacting the thin film with the wetted textured surface to adhere the thin film to the wetted textured surface by capillary action of the capillary bridges with the thin film; and releasing the adhered thin film from the thin film manipulator. Also disclosed is a thin film manipulator.

## Description

### Technical Field

The present disclosure relates particularly to thin films, associated methods and apparatus. Certain examples specifically concern an apparatus and method for thin film manipulation.

### Background

Research is currently being done to develop techniques for working with thin films.

The listing or discussion of a prior-published document or any background in this specification should not necessarily be taken as an acknowledgement that the document or background is part of the state of the art or is common general knowledge.

### Summary

According to a first aspect, there is provided a thin film manipulation method comprising:
wetting a textured surface of a thin film manipulator with a liquid, the textured surface comprising peaks separated by valleys, the liquid forming capillary bridges between the peaks of the textured surface;
picking up a thin film by contacting the thin film with the wetted textured surface to adhere the thin film to the wetted textured surface by capillary action of the capillary bridges with the thin film; and
releasing the adhered thin film from the thin film manipulator.

Releasing the thin film may comprise one or more of:
contacting the adhered thin film with a target substrate to adhere the thin film to the target substrate by substrate capillary action; the substrate capillary action being stronger than the capillary action of the capillary bridges acting to adhere the thin film to the wetted textured surface;
heating one or more of the liquid and the thin film manipulator;
applying a surfactant to the liquid;
drying the liquid;
evaporating the liquid;
illuminating the liquid with ultra violet light;
applying a fluid under pressure through the textured surface; and
stretching the textured surface.

Heating, applying a surfactant to the liquid, drying the liquid, evaporating the liquid, illuminating the liquid with ultra violet light, applying a fluid under pressure through the textured surface, and stretching the textured surface may cause at least some of the capillary bridges to break down, thereby weakening the overall capillary action acting to hold the thin film on the wetted textured surface.

Contacting the thin film with the wetted textured surface may comprise tilting the wetted textured surface with respect to a length of the thin film to gradually contact and adhere the thin film to the wetted textured surface across the length of the thin film.

The liquid wetting the textured surface may comprise one or more of: water, organic solvent, alcohol, ethanol, isopropanol, methanol, aldehyde, ketone, aromatic solvent, toluene, *N-*Methylpyrrolidone (NMP), and fluorinated solvent.

The textured surface comprises one or more of a conductive layer, a non-conductive layer, a nanoporous layer, a polymeric layer, a stretchable layer, a flexible layer, a metallic layer, a ceramic layer, a non-woven textile layer, an embossed layer, a moulded layer, and a woven polymeric yarn network. Suitable polymers for the textured surface comprise a film forming polymer, Poly(methyl methacrylate) (PMMA), Polyvinylpyrrolidone (PVP), Polyvinylacetate (PVA), Polyethylene (PE), Polyethylene terephthalate (PET), Poly(ethylene)naphthalate (PEN), Polyimide (PI), and a fluorinated polymer.

The textured surface may comprise one or more of:
a peak height range of between 1 µm and 5000 µm;
a peak separation range of between 1 µm and 5000 µm;
hemispherical, spherical, conical, rod-like, barrier-like and irregular peak shapes;
hemispherical, spherical, conical, cubic, cuboid-shaped, cylindrical, and irregular valley shapes.

The textured surface may be a planar textured surface. Contacting the thin film with the wetted textured surface may comprise: positioning an edge of the planar wetted textured surface at the thin film; and tilting the planar wetted textured surface with respect to a length of the thin film to gradually contact and adhere the thin film to the planar wetted textured surface across the length of the thin film.

The textured surface may be curved. Picking up the thin film may comprise rolling the curved textured surface with respect to the thin film. Releasing the thin film may comprise rolling the curved surface with the thin film adhered thereto with respect to the target substrate.

The textured surface may be on a pick-up belt. The pick-up belt may be supported on at least two rollers. Picking up the thin film may comprise rolling the pick-up belt with respect to the thin film.

The textured surface may be a thin film face of a porous belt, the porous belt having a porous structure with sufficient porosity to one or more of:
allow the formation of capillary bridges; and
allow the passage of a releasing fluid through the porous belt to facilitate release of the thin film adhered to the thin film face of the porous belt.

Picking up the thin film may comprise contacting the thin film with a high porosity belt layer of a layered porous belt. The layered porous belt may comprise the high porosity belt layer overlaying a low porosity belt layer. The low porosity belt layer may be configured to provide a barrier to releasing fluid used to break down the capillary bridges. The high porosity belt layer may be configured not to provide a barrier to releasing fluid used to break down the capillary bridges. Methods disclosed herein may comprise separating the overlaying high porosity belt layer from the low porosity belt layer to allow releasing fluid to be passed through the high porosity belt layer to the adhered thin film to facilitate release of the adhered thin film from the high porosity belt layer.

The releasing fluid may be a gas. Methods disclosed herein may comprise providing a gas flow through the high porosity belt layer to the adhered thin film to facilitate release of the adhered thin film from the high porosity belt layer by the removal of capillary bridges. Similarly a reduced gas pressure may be employed on one side of the high porosity belt layer to initiate thin film adhesion to the opposite side of the high porosity belt layer.

Wetting the textured surface may comprise wetting the textured surface with a liquid; and partially drying the textured surface to leave capillary bridges formed between the peaks of the textured surface.

According to a further aspect there is provided a thin film manipulator comprising:
a textured surface comprising peaks separated by valleys which is wetted with a liquid, the liquid forming capillary bridges between the peaks of the textured surface; the wetted textured surface configured to:
   pick up a thin film by contacting the thin film with the wetted textured surface to adhere the thin film to the wetted textured surface by capillary action of the capillary bridges with the thin film; and
   release the adhered thin film from the thin film manipulator.

The thin film manipulator may comprise one or more of: a stamp; a roller, and a continuous belt.

According to a further aspect, there is provided a method of making a thin film manipulator, the method comprising:
forming a textured surface comprising peaks separated by valleys; and
wetting the textured surface with a liquid, the liquid forming capillary bridges between the peaks of the textured surface;
the wetted textured surface configured to pick up a thin film by contacting the thin film with the wetted textured surface to adhere the thin film to the wetted textured surface by capillary action of the capillary bridges with the thin film; and release the adhered thin film from the thin film manipulator.

The steps of any method disclosed herein do not have to be performed in the exact order disclosed, unless explicitly stated or understood by the skilled person.

According to a further aspect, there is provided a computer program configured to perform any method described herein. Corresponding computer programs for implementing one or more steps of the methods disclosed herein are also within the present disclosure and are encompassed by one or more of the described example examples.

One or more of the computer programs may, when run on a computer, cause the computer to configure a thin film manipulator, apparatus or device disclosed herein or perform any method disclosed herein. One or more of the computer programs may be software implementations, and the computer may be considered as any appropriate hardware, including a digital signal processor, a microcontroller, and an implementation in read only memory (ROM), erasable programmable read only memory (EPROM) or electronically erasable programmable read only memory (EEPROM), as non-limiting examples. The software may be an assembly program.

One or more of the computer programs may be provided on a computer readable medium, which may be a physical computer readable medium such as a disc or a memory device, or may be embodied as a transient signal. Such a transient signal may be a network download, including an internet download.

Throughout the present specification, descriptors relating to relative orientation and position, such as "top", "bottom", "upper", "lower", "above, "below", "overlaying" and "underlying" as well as any adjective and adverb derivatives thereof, are used in the sense of the orientation of the apparatus as presented in the drawings. However, such descriptors are not intended to be in any way limiting to an intended use of the described or claimed invention.

The present disclosure includes one or more corresponding aspects, example examples or features in isolation or in various combinations whether or not specifically stated (including claimed) in that combination or in isolation. Corresponding means for performing one or more of the discussed functions are also within the present disclosure.

The above summary is intended to be merely exemplary and non-limiting.

### Brief Description of the Figures

A description is now given, by way of example only, with reference to the accompanying drawings, in which:-
Figure 1 a shows example schematic textured surfaces according to examples described herein;
Figure 1b shows the formation of capillary bridges according to examples described herein;
Figures 2a-2d show picking up a thin film according to examples described herein;
Figures 3a-3d show releasing a thin film according to examples described herein;
Figure 4 shows example planar textured surfaces (stamps) according to examples described herein;
Figure 5 shows an example curved textured surface (a roller) according to examples described herein;
Figure 6a and 6b show examples of textured surfaces on belts in roll-to-roll processes according to examples described herein;
Figure 7 shows an example curved textured surface and release of a thin film onto a rigid substrate according to examples described herein;
Figures 8a-8f show real-world examples of picking up and releasing a thin film according to examples described herein;
Figure 9 shows a schematic flow diagram of a thin film manipulation method according to examples described herein; and
Figure 10 shows a computer-readable medium comprising a computer program configured to perform, control or enable a method described herein.

### Description of Specific Aspects/Examples

Graphene and other two dimensional (2D) materials, which can all be considered as examples of thin films, have monolayer structures with interesting properties that are finding new applications due to unique properties such as high mobility and high charge carrier density. Graphene is a hexagonally ordered layer of carbon atoms and has a unique electronic band structure, with conic Dirac points at two inequivalent corners of the two-dimensional Brillouin zone. Several interesting features arise. These include the possibility of very high electron mobility, peculiar tunnelling and transport properties due to the linear dispersion relation near the Dirac points, and unusual excitation spectra in the quantum Hall regime with high magnetic fields. Graphene may exhibit magnetic order either due to intrinsic defects or impurities, or due to the spin alignment of edge states in finite systems. Graphene bi- and multilayers offer intriguing possibilities for device concepts. Similarly other 2D materials with the same structure, but using other elements, are also being explored such as Silicene, Phosphorene, Germanene, Borophene and Stanene based upon Silicon, Phosphorous, Germanium, Boron and Tin respectively. Similar structures that comprise more than one element such as Hexagonal Boron nitride (hBN) Molybdenum disulphide (MoS₂) and Tungsten diselenide (WSe₂) are similarly finding new applications in electronics and sensing devices.

Many applications for 2D materials are emerging, including thin film transistors (TFTs) with high mobility, and extremely charge sensitive field effect transistors based upon graphene (graphene field effect transistors, GFETs). Such devices require high quality near single crystalline 2D material that is generally grown by chemical vapour deposition (CVD), and this can lead to challenges with both the growth and transfer processes. In particular the removal and transfer of the single molecular layer of atoms from the growth substrate to the target device can prove challenging. This presents a manufacturing challenge since although the creation of graphene flakes may be performed, the fabrication of single crystalline graphene and other 2D materials currently requires a high temperature deposition onto copper substrates, followed by aggressive etching steps.

A significant problem with the production of 2D material based devices is in reliable growth and transfer of high quality crystalline material to the target device. Although, for example, graphene can be grown at high temperature (∼1000°C) on a range of different substrates, good results are generally obtained with a copper substrate, due to the favourable catalytic reactions and partial solubility of carbon in copper. The copper growth substrate can be, for example, a thin (∼100nm) evaporated layer on a silicon wafer, or a copper foil several tens of micrometres thick. After high temperature growth, the graphene monolayer must be removed from the growth substrate without damage and transferred onto the target substrate or device. This step is usually done manually, which limits the throughput and repeatability of using this material in commercial processes.

Several methods for graphene removal from a growth substrate such as a copper have been demonstrated including wet chemical etching to remove the copper layer by dissolution, electrochemical release of the graphene leaving the copper layer intact, pressure or heat sensitive adhesive tapes and high pressure/voltage combinations. Whilst the 'dry transfer' methods that use either pressure or heat release adhesive tape have been demonstrated as part of a continuous roll-to-roll process, the quality of the transferred graphene is generally not high, due to incomplete transfer of the continuous graphene layer, or contamination by adhesive residues that remain on the transferred graphene. Graphene transfer via 'wet transfer' in which the graphene is moved from a liquid surface to the target substrate generally results in higher quality graphene, since the liquid helps ensure uniform contact between the graphene and target substrate as a result of the capillary force acting both to level the graphene layer and bring it into close physical contact with the target substrate.

A sacrificial 'transfer layer' of solution coated polymer (often PMMA) may be used to aid with the handling of the delicate graphene monolayer. The transfer layer may be deposited onto the graphene before removal of the graphene/polymer from the growth substrate.

Despite using a transfer layer, handling graphene throughout these process steps presents significant challenges and the risk of damage to the graphene is present. Once all of the etching and rinsing steps have been completed, the final step may involve transferring the graphene from the rinse bath to the target substrate, which can be a rigid or flexible substrate. This is generally currently done by 'fishing out' the graphene which floats on the top of the water rinse bath, with the target substrate, and manually aligning the graphene and the target substrate. This is a particularly slow, labour intensive step that requires careful sample handling, and therefore limits the processing time of graphene transfer. Manipulation of graphene during the transfer process is a bottleneck for any industrial scale process.

Similar challenges may be faced when working with other 2-D and thin film materials.

One or more examples disclosed herein include methods of adhesive-free capillary bridge pick-up and 'wet transfer' of a thin film, such as a graphene sheet, that enable automation of the transfer process. Automation of thin film transfer may improve the processing speed and reduce the processing time of using thin films in manufacturing and processing. Automation of thin film transfer may also increase the placement accuracy of the thin film on the target substrate/device. One or more methods and apparatus disclosed herein may be applied to 2D materials (i.e. one atom thick, and in some examples substantially crystalline) and to multilayer materials which are several atoms thick but which may be considered as thin films.

One or more methods described herein may make it easier to align the thin film, for instance with critical device features, or with other existing thin films and/or 2D layers on the target substrate. Tiling of thin films to form a larger area may also be possible using methods described herein. One or more methods described herein use capillary forces generated by thin liquid films to pick up thin films, and do not use any adhesives (e.g., glues) to pick up and deposit the thin films. Thus there the risk of contamination or of leaving adhesive residue on the thin film may be reduced.

Since the thin films manipulated according to one or more methods described herein may be repeatably held and transferred, such methods may improve the alignment capability of the thin film handling process to align the thin film with a target substrate. One or more methods described herein using capillary-bridge assisted picking up and release of a thin film may be beneficial for large scale and automated transfer processes. Capillary bridge assisted rotary manipulation may also make it possible for thin films to be manipulated in continuous roll-to-roll processes.

Capillary forces are responsible for a range of phenomena, such as liquid permeation into porous media, and long range attraction between surfaces via the formation of so-called 'capillary bridges' which can form over length scales ranging from a few nanometres to several millimetres. The origin of the attractive capillary force is the creation of new free surface: surface tension tries to reduce the surface area while pressure tries to increase the volume, and so forming a capillary bridge increases the total free energy of the system.

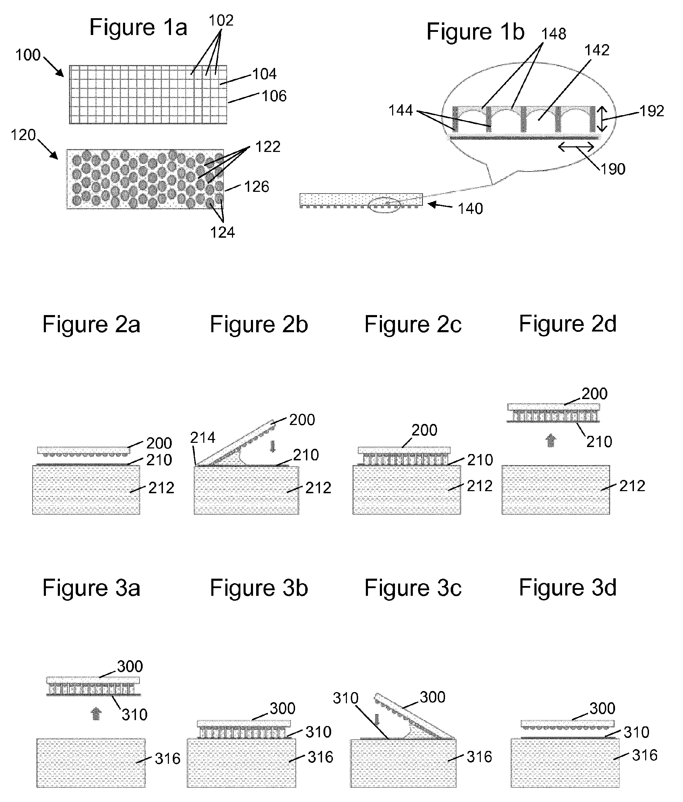

Figure 1a shows example schematic textured surfaces 100, 120. Textured surfaces described herein may in some examples be porous surfaces. A plurality of capillary bridges may be formed using a textured surface 100, 120. One example textured surface 100 comprising a network of cavities 102 is shown in the top of Figure 1a. Such a textured surface 100 may be formed by laminating a woven mesh 104 (for example, having a cell/cavity size of around 1mm to 5mm across) on top of a substrate 106 (the substrate comprising, for example, a flexible film, rubber, etc.). The cavities 102 may be considered to be square/rectangular shaped valleys separated by woven mesh 104 peaks. Capillary bridges may form within the cavities 102 between the peaks of the textured surface. The textured surface 100 in this example may be termed a capillary net because it comprises a mesh/net 104 acting to trap liquid in the mesh/net holes 102 and form a series of capillary bridges using the liquid trapped in the holes 102 of the mesh/net 104.

The bottom of Figure 1a illustrates another way of forming a textured surface. In this example spherical objects 124 have been deposited on top of a substrate 126. Capillary bridges can form between the spheres 124 (the spheres 124 may be considered to be peaks and the spaces/cavities 122 between the spheres 124 may be considered to be valleys 122, with capillary bridges forming between the sphere 124 "peaks").

Other example methods of forming a textured surface include using laser cutting, e.g. to form small cavities with circular or hexagonal morphology of a few tens of micrometres diameter. These cavities may be made much smaller than those formed by a woven mesh or deposited spherical objects as described above. Laser cutting to form such features of this smaller size is used in engraving gravure rollers for rotary gravure printing presses.

Figure 1b shows the formation of capillary bridges 148 according to examples described herein. A textured surface 140 comprises peaks 144 separated by valleys 142. The textured surface 140 has been wetted with a liquid, and the liquid has formed capillary bridges 148 between the peaks 144 of the textured surface 140. Such a wetted textured surface may be used as part of a thin film manipulator for manipulating (e.g., picking up and releasing) thin films.

The textured surface 140 may comprise one or more of: a peak height 192 range of between 1 to 5000µm and a peak separation 190 range of between 1 to 5000 µm.

The textured surface 140 may comprise one or more of: hemispherical, spherical, conical, rod-like, barrier-like and irregular peak shapes. Figure 1 b shows a cross-section through barrier-like peak shapes formed from a woven mesh used to make the textures surface. For example in some examples the textured surface may comprise a porous plastic film, having regular spaced holes with a diameter of 500µm and a depth of 1000µm separated by a distance of 500µm. In other examples the textured surface may be a steel roller surface engraved with laser cut holes or diamonds of approximately 10-100 µm diameter and a depth of 10 - 50µm. The textured roller surface may be covered with thin layer of another metal such as chromium or nickel, which in turn may have a thin surface layer configured to change the surface energy of the textured surface. In some other examples the textured surface might be realised by hot embossing, where gravure of the hot embossing stamp is copied to a polymeric film by the application of pressure and heat.

The bottom portion of Figure 1a shows spherical peak shapes formed by spherical objects deposited on a substrate. The textured surface 140 may comprise one or more of: hemispherical, spherical, conical, cubic, cuboid-shaped, cylindrical, and irregular valley shapes. Figure 1b shows cubic or cuboid shaped valley shapes formed from the space in-between the material of the woven mesh used to make the textured surface. In the example of a textured surface manufactured using engraving or laser cutting the valley shapes may be cut into, for example, conical, hexagonal, cylindrical or hemispherical pores, U or V-shaped valleys running in one, two or more directions, or any other suitable valley shape or shapes.

The liquid which may be used to wet the textured surface and form the capillary bridges may be, for example, water, polar or non-polar liquids, organic solvents such as alcohols like ethanol, isopropanol, methanol, aldehydes, ketones, aromatic solvents such as toluene, NMP, or fluorinated solvents, or mixtures of two or more of these liquids.

In some examples the textured surface 140 may be partially dried after wetting with a liquid to leave capillary bridges 148 formed between the peaks 144 (in the valleys 142) of the textured surface 140. This may be considered to be a process of pre-wetting the textured surface, followed by surface drying, to achieve a wetted textured surface 140. Surface drying may be done by touching the initially wetted textured surface with dry absorbent paper, for example. This procedure may generate a plurality of capillary bridge-cells 148 within valleys 142 of the textured surface 140, which at the picking side are dry (i.e. at the tips of the peaks 144, which as shown in Figure 1 b are at the bottoms of the hanging features 144 which is the face which is configured to contact a thin film to be manipulated) but have wet tops (i.e. the bottom of the valleys 142 contain the wetting liquid in between the peaks 144). Such a procedure can produce a huge number of capillary bridges 148 ready to be used, for example, for the gentle pick up of a fragile thin film sample as shown in Figures 2a-2d.

It may be desirable to control the morphology of the textured surface 100, 120, 140, for example to tune the properties of the capillary bridges 148 formed (such as the strength of adhesion of a thin film to the wetted textured surface). A series of capillary bridges can be engineered with particular properties in different ways.

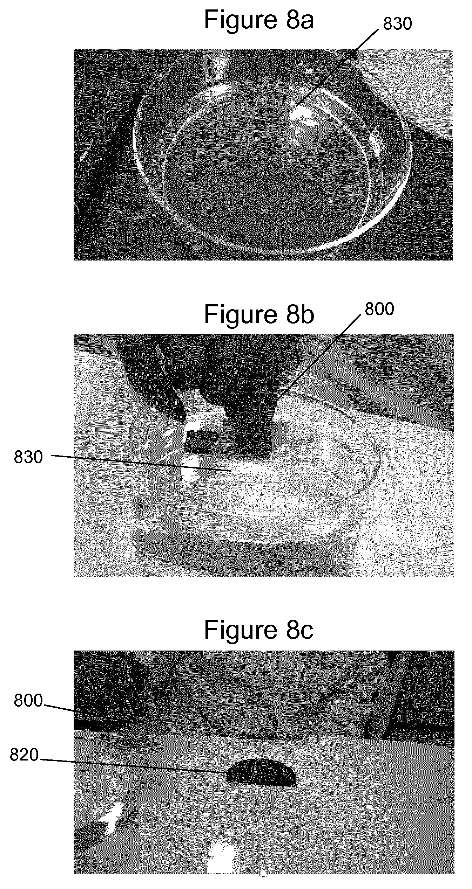

If the textured surface 140 comprises a porous membrane then a range of possible porous membranes may be used, each providing different adhesion properties. For example, Sati ® acoustic membranes may be used (as described in relation to Figures 8a-8f below) having a porous structure of a suitable length scale for capillary bridge formation as described elsewhere herein. A conductive membrane may be used to allow the application of voltage across the membrane and thus across a thin film adhered to the membrane. Filter membranes such as Anodisc/Anopore nano-porous membranes may be used to form the textured surface. Stretchable membranes or polymeric membranes may be used as a textured surface, where the pore diameter can be changed to allow for tuning of the release of a thin film from the wetted textured surface membrane (i.e. by capillary bridge breaking by changing the dimensions of the pores/openings).

The morphology of the textured surface 140 may also be engineered to achieve a series of capillary bridges with particular properties using the wetted textured surface. The shape, size and distribution of peaks and valleys (i.e. bumps) in the textured surface may be tuned to obtain particular roughness characteristics. Generally spherical morphologies may be advantageous since these can be used to achieve stable meniscus pinning of the liquid capillary bridges with a circular wetting line. The number and size of bumps/peaks can be used to tune the number and size of capillary bridges which form. That is, a large number of small bridges may be more appropriate when the textured surface and thin film to be adhered to the textured surface are in close proximity (i.e. separated by about 10nm to about 100nm). Fewer larger bridges might be more appropriate if the textured surface and thin film are separated by a greater distance, for example over a micrometre or millimetre length scale.

Further, surface energy patterns may be formed on the textured surface to define liquid regions (i.e. regions where capillary bridges are to form). For example, UV switching of surface energy may be used to remove capillary bridges from the wetted textured surface in the case where a surface energy pattern is used to define the capillary bridges i.e. when the capillary bridges are initially formed from regions of high surface energy (wetting) surrounded by regions of low surface energy (non-wetting). If the surface energy pattern is created using a UV sensitive material for the textured substrate such as titanium dioxide, the pattern can be reversibly switched from low to high surface energy and vice versa by exposure to UV light, thus allowing capillary bridges to be created or destroyed.

Other ways of controlled release/breaking of capillary bridges include heating the liquid forming the capillary bridges, heating the thin film manipulator (which in turn causes the capillary bridge liquid to heat up); applying a surfactant to the liquid; drying the liquid forming the capillary bridges, for example using a desiccant or dry atmosphere; evaporating the liquid forming the capillary bridges; illuminating the liquid with ultra violet (UV) light); applying a fluid (e.g., air) under pressure through the textured surface; and stretching the textured surface.

Heating, evaporating, or drying the liquid may cause a reduction or break down of the capillary bridges by shrinking the bridges, in some examples by shrinking them by so much that there is no longer sufficient liquid to form a capillary bridge (and thereby span the separation of peaks in the textured surface). Applying a surfactant to the liquid may cause a breakdown of the capillary bridges by changing the surface tension or other liquid properties of the liquid such that capillary bridges can no longer form (for example the liquid may not remain within the pores/between peaks in the textured surface). Illuminating the liquid with ultra violet light may cause a break down at least some of the capillary bridges due to the UV light causing a change in the surface energy. Applying a fluid under pressure through the textured surface may cause a break down in the capillary bridges by forcing fluid (e.g., air) through the pores of the textured surface and physically forcing the liquid of the capillary bridges to disperse by blowing it out of the textured surface, for example. Stretching the textured surface may cause at least some of the capillary bridges to break down by physically pulling/pushing the capillary bridges apart such that the liquid forming the bridge can no longer remain forming a bridge in the pore/between the peaks in the textured surface. Breaking down at least some of the capillary bridges may weaken the overall capillary action acting to hold the thin film on the wetted textured surface.

It may be desirable to have a tuneable pore diameter of the textured surface, for example by the textured surface being flexible and/or stretchable.

Figures 2a-2d show the method of using a thin film manipulator 200 to pick up a thin film according to examples described herein. In this example the thin film 210 is in a liquid environment (i.e. is floating on the surface of a liquid 212) and the wetted textured surface 200 is ready to be contacted with the thin film 210. In Figure 2b the thin film 210 is contacted by the wetted textured surface 200 by tilting the wetted textured surface 200 with respect to a length of the thin film 210 to gradually contact and adhere the thin film 210 to the wetted textured surface 200 across the length of the thin film 210. The thin film 210 is adhered to the wetted textured surface 200 by capillary action of the capillary bridges with the thin film 200.

In this example the textured surface 210 is a planar textured surface. Figure 2b shows the method of positioning an edge 214 of the planar wetted textured surface 200 at the thin film 210. Then the planar wetted textured surface 200 is tilted with respect to a length of the thin film 210 to gradually contact and adhere the thin film 210 to the planar wetted textured surface 200 across the length of the thin film 210. Figure 2c shows that the planar wetted textured surface 200 is coplanar with and in contact with the entire thin film 210. The textured surface 200 may then be lifted away from the liquid support 212 and the adhered thin film 210 is lifted away with (i.e. picked up by) the capillary bridges in the textured surface 200 as shown in Figure 2d.

Figures 3a-3d show releasing a thin film from the thin film manipulator according to examples described herein. In this example the thin film 310 is released onto a target substrate 316. The wetted textured surface 300 with the thin film 310 adhered thereto is brought towards the target substrate 316 in Figure 3a. In Figure 3b the thin film 310 is contacted at a co-planar angle with the target substrate 316. In this example the thin film 310 is adhered to the target substrate 316 by substrate capillary action. The substrate capillary action is stronger than the capillary action of the capillary bridges acting to adhere the thin film 310 to the wetted textured surface 300. Therefore in Figure 3c, the textured surface 30 is tilted away from the thin film 310 / target substrate 316 surface and the thin film remains adhered to the target substrate 316 due to the substrate capillary action of the substrate 316 on the thin film. In Figure 3d the textured surface 300 has been removed leaving the thin film 310 adhered to the target substrate 316.

The surface adhesion with the target substrate may be engineered to be stronger than the capillary action of the capillary bridges holding the thin film onto the thin film manipulator. For example, rendering the target substrate to have a higher surface energy than the textured surface will increase the adhesion / wetting between the transfer liquid and the target substrate and help to overcome the capillary forces to allow for deposition of the thin film onto the target substrate. This can be achieved, for example, by using a surface activation process such as oxygen or atmospheric plasma, corona discharge treatment, deep UV exposure or chemical adhesion promotors.

In other examples of releasing the thin film, the step of contacting the thin film 310 adhered to the wetted textured surface 300 with the target substrate 316 may be done by tilting the wetted textured surface 300 with the thin film 310 adhered thereto with respect to the target substrate 316 surface, to gradually contact and adhere the thin film 310 to the target substrate 316 across the length of the thin film 310.

In other examples, the adhered thin film 310 may be released from the wetted textured surface 300 in different ways. There may be preferential adhesion with the target substrate 316 than with the wetted thin film 300 (as described above). One or more of the liquid and the thin film manipulator 300 may be heated to evaporate/break, and thereby weaken the capillary action of the capillary bridges on the thin film. For an aqueous liquid this generally requires heating to temperatures greater than 50 °C or more, but if a more volatile transfer liquid such as isopropyl alcohol (IPA) or ethanol is used much lower temperatures can also be effective in weakening capillary action of capillary bridges on a thin film.

For aqueous transfer liquids a surfactant may be applied to the liquid forming the capillary bridges to break up the capillary bridges, to significantly lower the surface tension. The liquid forming the capillary bridges may be dried/evaporated to break up and remove the capillary bridges, for example by application of a vacuum or reduced pressure to increase the evaporation rate. A fluid may be applied under pressure through the textured surface to break down at least some of the capillary bridges by "flooding" the textured surface, thereby removing the capillary bridges. Such a fluid may be air, for example. Air (or other inert gas) may be provided at a pressure above ambient pressure.

The textured surface may be flexed and/or stretched to break at least some of the formed capillary bridges (for example, if the textured surface is a stretchable polymer mesh in the belt or stamp configuration).

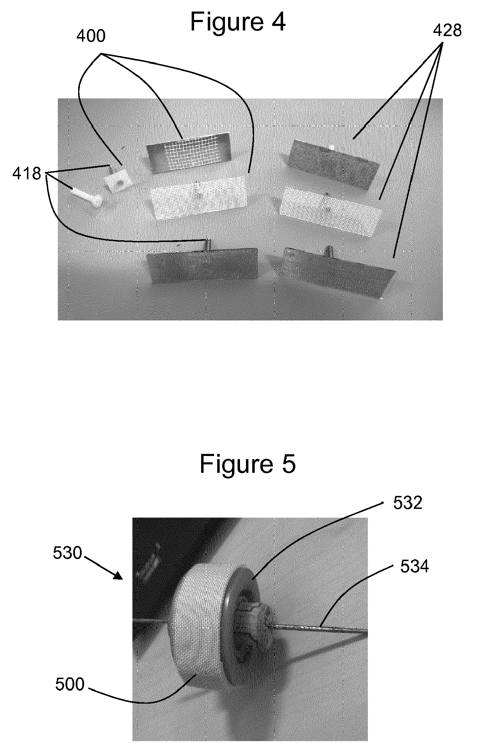

Figure 4 shows an example planar textured surface 400 (on a flat stamp 428). A stamp 428 may consist of a substrate (e.g. glass, rubber), a capillary net/mesh or other textured layer 400 attached to the substrate and a manipulation handle 418 so the stamp may be moved manually or through use of a machine. The textured surface 400 may be realized in a number of different form factors as shown in Figure 4. That is, different granularities/pore sizes may be used and each will provide different properties for adhering a thin film to the wetted textured surface of each stamp by allowing the formation of capillary bridges with different adhesion properties. Smaller pores may have a greater adhesion force than larger pores. The magnitude of the adhesion force may scale with 2γcosθ/r where r is the radius of the pore, γ the surface tension and θ the contact angle. In these stamp examples 428, a user can manually operate the pick-up, transfer and deposition of a thin film to another substrate by holding a handle 418 attached to the textured surface 400.

Figure 5 shows an example curved textured surface (a roller). This roller 530 comprises a rigid roller part 532 on an axle 534 and the rigid roller 532 is covered with an elastic layer (rubber for example). On top of the elastic layer there is a capillary net 500 to provide a wetted textured surface when wetted. When the roller 530 rotates with respect to and in contacting proximity to a thin film (i.e. the roller 530 rolls over a thin film, or a thin film is moved laterally past and in contact with the roller 530 surface, or a combination of the two which results in a net movement of the roller 530 with respect to the thin film), the wetted textured surface 530 of the roller picks up the thin film. A particular example of this is a gravure roller such as is used in rotary gravure printing. The manufacturing capability to create custom, high resolution patterns in such a gravure roller is well established, and a large range of material finishes are available such as chromium plated mild steel, ceramic or polymer, which further allows for the properties of the textured surface and thus the capillary bridges to be fine-tuned.

The stamp 428 and the roller 530 may be considered to be, or be part of, a thin film manipulator, the thin film manipulator comprising: a textured surface 400, 500 comprising peaks separated by valleys which is wetted with a liquid, the liquid forming capillary bridges between the peaks of the textured surface 400, 500; the wetted textured surface configured to: pick up a thin film by contacting the thin film with the wetted textured surface to adhere the thin film to the wetted textured surface by capillary action of the capillary bridges with the thin film; and release the adhered thin film from the thin film manipulator.

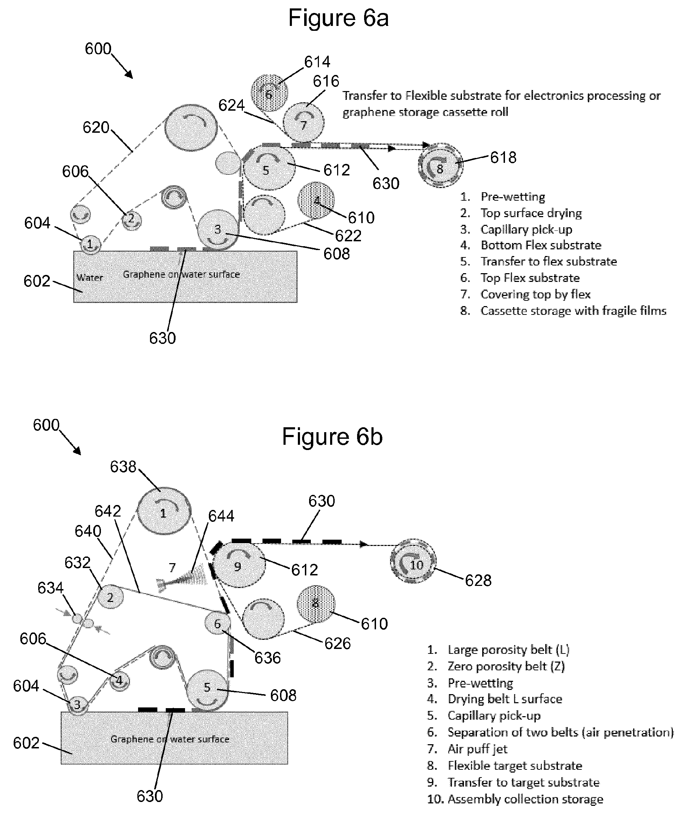

Figure 6a and 6b show examples of textured surfaces on continuous belts. A further way of using a textured surface in a more industrial-style manipulating technique is by using a belt or continuous web/surface (e.g. a belt capillary net) having a textured surface. Such a belt can be tensioned, for example by being supported on two or more rollers, and guided using the rollers to provide a continuous fast way of picking up and transporting fragile thin films from one place to another, and depositing the thin films after transporting them, with reduced disturbances to the thin film (i.e. reduced risk of tearing or folding of the thin film). The capability for in-line and cross-width registration of the belt with the thin film is readily available to allow the system to accurately align critical features on the belt with those on the target substrate since whilst the liquid transfer layer is present, it acts as a lubricating layer and it is possible to perform small sliding movements of the 2D material on the target substrate without damaging the 2D material.

Roll-to-roll (R2R) manufacturing based on continuous web processes may be viewed as a promising route for high-throughput production of printed and solution-processed electronics. It is desirable, for example, to develop roll-to-roll graphene and other thin film manufacture and manipulating methods. Currently wet transfer methods by using a thin polymer supporting layer are limited in roll-to-roll processes. Roll-to-roll transfer of thin films onto a polymer substrate is possible using the apparatus and methods described in relation to Figures 6a and 6b below.

Figure 6a shows an example of a roll-to-roll process in which a thin film 630 (e.g., graphene) is picked up and transported using a first belt 620, and transferred onto a second belt 622 for subsequent release at a cassette storage roller 618. The second belt 622 may be considered to be a flexible target substrate.

In this example, the textured surface 620 used to pick up the thin film 630 is curved (the belt 620 is supported over a curved roller 608). Picking up the thin film 630 comprises rolling the curved textured surface 620 at the pick-up roller 608 with respect to the thin film 630. The textured surface 620 in this example is on a pick-up belt 620 held on at least two rollers, and picking up the thin film 630 comprises rolling the pick-up belt 620 with respect to the thin film 630.

The apparatus 600 shown in Figure 6a comprises belts 620, 622 each having a textured surface for contacting the thin films 630. Such belts 620, 622 may be made from mesh or webbing, for example. The belts 620, 622 are tensioned between several rollers 604, 606, 608 which guide the path of a picked-up thin film 630 to the end of the manipulation process. The rollers shown in Figure 6a include a pre-wetting roller 604, a top surface drying roller 606, a capillary pick-up roller 608 for picking up the thin films 630, a bottom flex substrate roller 610, a transfer roller 612 to transfer a thin film to the bottom flex substrate 622, a top flex substrate roller 616 to apply a top flex substrate 624 from a top flex roller 614 to the top of the thin film 630, and a cassette storage roller 618 to store the picked-up thin film 630 laid between top 624 and bottom 622 flex substrates/layers. Of course this is just one example of a roll-to-roll process and the skilled person will understand many other variations exist.

The process starts with pre-wetting of the belt 620 using a pre-wetting roller 604 in the tank reservoir containing water 602 where the thin film samples 630 are. This step helps ensure that the belt 620 is wet and that capillary bridges are formed by the liquid 602 between the peaks in the textured surface of the belt 620.

The next step is drying the top surface of the belt 620 by passing the belt 620 over a drying roller 606 (e.g. the roller 606 may be covered with an absorbent paper, sponge, or another porous medium). In other examples an air knife may be used to partially dry the belt 620. An air knife may be configured to partially evacuate the liquid 602 from the very top surface of the belt 620 and allow capillary bridges to form in the pores of the belt 620 (in the valleys of the textured surface). After the partial drying, liquid 602 traces stay at the bottom of the cells/pores in the textured surface of the belt 620 thereby providing a plurality of capillary bridges enclosed within the cells/pores. This method prepares the belt 620 for efficient picking up of the thin films 630 via a capillary lifting force as previously described.

A sample of thin film 630 is picked up by the belt 620 on a pickup roller 608. The roller 608 is shown to rotate anticlockwise, and when in intimate contact with the thin film sample 630 floating on the surface of the liquid 602 the belt 620 picks up the thin film sample 630 by capillary action of the capillary bridges within its textured surface, and transports the thin film 630 along the processing path (towards the final roller/cassette 618).

The thin film sample 630 is taken off the pick-up roll-to-roll belt/loop 620 by using a second belt 622, which may be termed a manipulation/storage belt 622 which operates using a transfer roller 612. When brought into intimate contact at the transfer roller 612, the thin film sample 630 is transferred from the pick-up belt 620 to the second belt 622 in the roll-to-roll line 600. In some examples a gentle pressure may be applied to the thin film 630 to aid the transfer process. Thus releasing the thin film 630 comprises rolling the curved surface 620 with the thin film 630 adhered thereto with respect to the target substrate 622 (in this case the second belt 622 may be considered a target substrate).

In this example the second belt 622 comprises a flexible substrate on which the thin film 630 may be transferred for subsequent use or storage. The surface adhesion of the second belt 622 is higher than the surface adhesion of the pick-up belt 620 (due to the capillary bridges formed at the textured surface 620). That is, a thin film sample 620 will preferentially adhere to the second belt 622 than the first pick-up belt 620. This may be, for example, because the second belt 622 comprises a textured surface in which capillary bridges are present, but the nature of the second belt 622 compared with the first belt 620 means that the capillary bridges of the second belt 622 provide a stronger adhesive/attractive force acting to adhere a thin film to the second belt 622 than the adhesive/attractive force provided by the capillary bridges of the first belt 620. For example the two belts 620, 622 may comprise different pore sizes, pore density (number of pores per area of the belt), pore depths, may be constructed of different materials, or may be wetted with different liquids. Transfer of the thin film from one to another belt may be determined by the respective attractive forces provided by two belts on the thin film. The thin film will be adhered to the belt which provides stronger attraction with the thin film, the attraction arising due at least in part to the nature of the capillary bridges on each belt. For example a stronger net force can be provided by the second belt 622 than the first belt 620 if the density of the capillary bridges (number of bridges per area) is greater on the second belt 622 comparing to the first belt 620. The two belts 620, 622 may be pre-wetted by the same liquid in some examples or by different liquids separately in other examples.

In Figure 6a the next step in the process shows protection and safe storage of the thin film 630 by applying a top coating using a second flexible protective film 624 supplied from a top flex coating roll 614. The flexible substrate 622 with the thin film 630 adhered thereto passes under the top flex application roller 616 which presses the top flux layer 624 onto the thin films 630. The thin film 630, sandwiched between a flexible substrate 622 and a protective top layer 624, may be rolled onto cassette-like storage roller 618. In other examples, the thin film 630 on the transfer substrate 622 may be delivered to a final location for use, for example in an electronic assembly process.

Such an arrangement as shown in Figure 6a may be used to produce a batch of easy-to-use thin films 630 saved in a cassette 618 which can be safely transported to another fabrication processing location, or be sold as a product with the advantageous benefit of being easy to use i.e. not bound to a difficult-to-remove substrate. In the example of the thin film being a graphene film, such films are often commercially available on a copper substrate due to the graphene manufacturing process. In the example shown in Figure 6a, the graphene is advantageously not on a copper substrate (which must be etched away before the graphene can be used) and can therefore more readily be used.

Figure 6b depicts a two-layer belt based system for thin film manipulation. The apparatus 600 shown in Figure 6b comprises belts 640, 642; 626 having a textured surface for contacting the thin films 630. The belts 640, 642; 626 are tensioned between several rollers 604, 606, 608, 632, 636, 638 which guide the path of a picked-up thin film 630. The rollers shown in Figure 6b include a pre-wetting roller 604, a top surface drying roller 606, a capillary pick-up roller 608 for picking up the thin films 630, a separation roller 636 at which the high and low porosity belt layers 640, 642 of the pick-up belt are separated, a belt laminating roller 632 at which the separated high and low porosity belt layers 640, 642 are recombined into a dual layer belt (aided by the compression rollers 634 acting to press the high and low porosity belt layers 640, 642 together into a dual layer belt), a high porosity belt layer roller 638, a bottom flex substrate roller 610, and a transfer roller 612 for transferring a thin film 630 to the bottom flex substrate 626. Of course this is just one example of a roll-to-roll process 600 and the skilled person will understand many other variations exist.

This is an example of a two belt 640, 642 system (the two belts having high 640 and low 642 porosities respectively) which are separated (in this example at the separation roller 636) prior to the thin film releasing/donating point at the transfer roller 612 in the roll-to-roll process. The apparatus 600 comprises a dual-layer belt 640, 642 in which each belt layer 640, 642 has a different porosity. In some embodiments the low porosity layer 642 may not be porous (i.e. it may be made of solid flexible material with no pores). For example it may be made of a polymeric material such as butyl rubber or neoprene rubber. In other examples the low porosity belt layer 642 may have narrow pores of approximately 1 µm or less that require a very large pressure to remove liquid from. The high porosity belt layer 640 has larger pores than the low porosity belt layer, for example pores in the high porosity belt layer 640 may have a diameter between 10µm to 5000 µm suitable to facilitate capillary bridge formation therein. A high porosity belt layer with extra large pores (approximately 5000 µm in diameter) might be used and comprise, for example, a mesh/net-like textile belt with large 5000 µm diameter cavities between the yarns forming the mesh.

The dual layer belt 640, 642 is a pick-up belt which comprises a textured surface. The pick-up belt 640, 642 is held on at least two rollers. Picking up a thin film 630 comprises rolling the pick-up belt 640, 642 with respect to the thin film 630. The textured surface in this example is located at a thin film face of the porous belt 640, the porous belt 640 having a porous structure with sufficient porosity to allow the formation of capillary bridges and allow the passage of a releasing fluid (e.g., air) through the porous belt 640 to facilitate release of the thin film 630 adhered to the thin film face of the porous belt 640 when the two belts 640, 642 are separated at the separation roller 636. To enable the air penetrating on the back side (opposite to face side) of the high porosity belt layer 640 (after separation point at 636) to pass through the belt 640, the porosity of the belt 640 may for example comprise pores larger than 200 µm (for example, a net or mesh like belt 640 may be used to achieve this pore size.)

The material used for the outer belt 640 (which is configured to contact and adhere a thin film 630 thereto) has a relatively high porosity which enables the formation of capillary bridges within the pores of the belt 640, and allows for a relatively easy penetration of air through the belt 640. The second inner belt layer 642 of the dual layer belt 640, 642 is made of a relatively low porosity material which presents a very good barrier to liquids and gases (i.e. fluids), at least to the extent to stop the breaking of formed capillary bridges in the high porosity outer belt 640 when required. These two belts 640, 642 are brought together such that one overlays the other (i.e. they may be considered to be temporarily laminated). When brought together the two belt layers 640, 642 provide a network of enclosed capillary bridges on a thin film side of the belt 640, 642 which allow for the pick-up of thin films 630. The capillary bridges may be considered enclosed because the low porosity belt layer 642 provides a low porosity back layer to enclose the back side of the high porosity belt layer 640 in which the capillary bridges form between peaks in the textured thin film surface (i.e. the side of the high porosity belt layer 640 configured to contact and pick up thin films 630).

The arrangement of Figure 6b is different to that of Figure 6a, in part because the release of the thin film 630 from the pick-up belt 640, 642 is different. Prior to releasing the thin film 630 onto a target substrate 626 (in this example onto a flexible target substrate 626), the two layers 640, 642 of the dual layer belt are separated/pulled apart, as shown occurring at the belt layer separation roller 636. By separating the high porosity belt layer 640 from the low porosity belt layer 642, air (and other fluid) is able to penetrate from the back side of the high porosity belt layer 640 through to the thin film face of the high porosity belt layer 640. This action of air flow through the high porosity belt layer 640 acts to remove the backing of the capillary bridges, ultimately removing/breaking the capillary bridge. The air flow may also act to push the thin film 630 away from the thin film face of the high porosity belt layer 640. Thus the air can penetrate through the high porosity belt layer 640 and aids release of the thin film 630.

In other words, Figure 6b illustrates that picking up the thin film 630 comprises contacting the thin film 630 with a high porosity belt layer 640 of a layered porous belt 640, 642, the layered porous belt 640, 642 comprising the high porosity belt layer 640 overlaying a low porosity belt layer 642, the low porosity belt layer 642 configured to provide a barrier to releasing fluid used to break down the capillary bridges; the high porosity belt layer 640 configured not to provide a barrier to releasing fluid used to break down the capillary bridges. Separating the overlaying high porosity belt layer 640 from the low porosity belt layer 642 can take place to allow releasing fluid (e.g. air) to be passed through the high porosity belt layer 640 to the adhered thin film 630 to facilitate release of the adhered thin film 630 from the high porosity belt layer 640.

The release of the thin film 630 may be aided in some examples by using an air jet 644 which can be placed where the thin film 630 is to be transferred to the target substrate 626 and configured to provide a puff of air through the high porosity belt layer 640 to help release an adhered thin film 630 from the belt layer 640. The air jet may be synchronized with the belt moving system 600. Once the positions of the thin film 630 with the target substrate 626 are aligned the air jet 644 can be activated.

In other words, a releasing fluid may be used, in this example a gas (air). A gas flow is provided through the high porosity belt layer 640 to the adhered thin film 630 to facilitate release of the adhered thin film 630 from the high porosity belt layer 640 by the removal of capillary bridges from the high porosity belt layer 640.

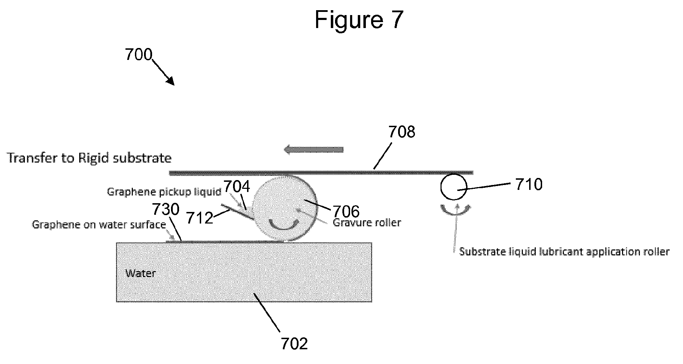

Figure 7 shows an example curved textured surface and release of a thin film onto a rigid substrate according to examples described herein. The apparatus 700 in Figure 7 may be termed a gravure-type apparatus for thin film pick-up and deposition/release. In this example, the textured surface is present on the curved surface of a gravure-type roller 706. The textured surface may be realised using, for example, a mesh layer to form a series of pores in which capillary bridges may form once the mesh layer is wet, as in Figure 5. Pre-wetting of the capillary net may be performed by application of a suitable liquid 704 inserted between a blade 712 and the roller 706. When the roller 706 rotates, an amount of the liquid 704 is deposited at the bottom of the mesh net cells, while at the same time the surface of the blade 712 in contact with the roller 706 removes any liquid 704 excess from the top surface of the mesh net. The resulting effect is that the cells in the textured surface of the roller 706 are supplied with a small amount of liquid 704 at the bottom of the cells to form capillary bridges, whilst removing excess liquid from the surface of the roller 706 using the blade 712. This configuration can provide a good way of forming capillary bridges to allow for pick-up of thin films when brought into intimate contact with the textured surface of the roller 706. The thin films 730 in this example are floating on water 702.

In this example the textured surface of the roller 706 in which capillary bridges can form is curved. Picking up a thin film 730 comprises rolling the curved textured surface 706 with respect to the thin film 730. Releasing the thin film 730 comprises rolling the curved surface 706 with the thin film 730 adhered thereto with respect to the target substrate 708. The target substrate 708 in this example is a rigid substrate which is translated/moved from right to left as shown over the roller 706, and the rotating roller 706 which has a thin film 730 adhered to its surface releases the thin film 730 onto the rigid substrate 708 as it passes over the roller 706.

In this example the rigid substrate 708 is wetted with a substrate liquid lubricant by passing over a substrate liquid lubricant applicant roller 710. Thin film transfer in this example is facilitated by using a both a lubricating liquid and a graphene pickup liquid 704. The two liquids may have different surface tensions and boiling points. For example, using a pickup liquid 704 with a lower surface tension compared to the substrate lubricating liquid helps to ensure adhesion forces to the substrate 708 are stronger than to the transfer roller 706.

In the above examples in relation to a picking up a thin film using a textured surface moving relative to the thin film so that the thin film is picked up and adhered to the textured surface, it may be that the textured surface moves over the thin film (such as by rolling over it); it may be that the thin film is slid past the textured surface, for example on a conveyor belt; or it may be that both the textured surface and the thin film are moving with a net difference in motion between the two. Similarly in relation to releasing the thin film, it may be that the target substrate moves over the thin film (such as shown in Figure 7 in the gravure-type process where the rigid substrate is translated from right to left over the roller onto which the thin film in adhered); it may be that the thin film is slid past the target substrate (for example on a roller or belt rolling over the target substrate); or it may be that both the thin film and the target substrate are moving with a net difference in motion between the two.

Figures 8a-8f show real-world examples of picking up and releasing a thin film according to examples described herein. In this experiment, graphene as an example of a thin film was grown on a 25 µm thick copper foil by chemical vapour deposition CVD (using an Aixtron Black Magic CVD system). CVD of graphene on copper in this example comprises an initial annealing phase in a hydrogen/argon atmosphere and a growth phase, in which a methane precursor is introduced in the growth chamber.

After growth of the graphene, a polymer (poly(methyl methacrylate) (PMMA)) layer is spin-coated (at 1000 rpm for two minutes, followed by curing at 150°C for 30 minutes) on the graphene (the PMMA thin film is present as a supporting layer to aid transfer). To aid manipulation of the graphene, a rigid poly(ethylene)naphthalate (PEN) frame is attached to the polymer/graphene structure by using optical clear adhesive (OCA).

Wet chemical etching using Ferric Chloride is used to remove the Cu then subsequently, the frame/PMMA/graphene stack is rinsed in deionized water. The frame/PMMA/graphene film 830 remains floating on the surface of the deionised water (as shown in Figure 8a). The PMMA/graphene portion of the layer is about 1 µm thick and the frame/PMMA/graphene portion of the layer is about 50 µm thick.

Figures 8b-8f illustrate three types of textured surface-assisted manipulation of a 2D graphene thin film.

In Figure 8b the graphene thin film 830 is adhered to a textured surface which is part of a capillary stamp manipulator 800 (similar to those shown in Figure 4). The textured surface in this example comprises a Sati ® acoustic membrane which has a porous texture. The adhered thin film is then transferred from the textured surface of the capillary stamp manipulator 800 to a SiO₂/Si wafer 820 (shown in Figure 8c), the wafer 820 being a target substrate.

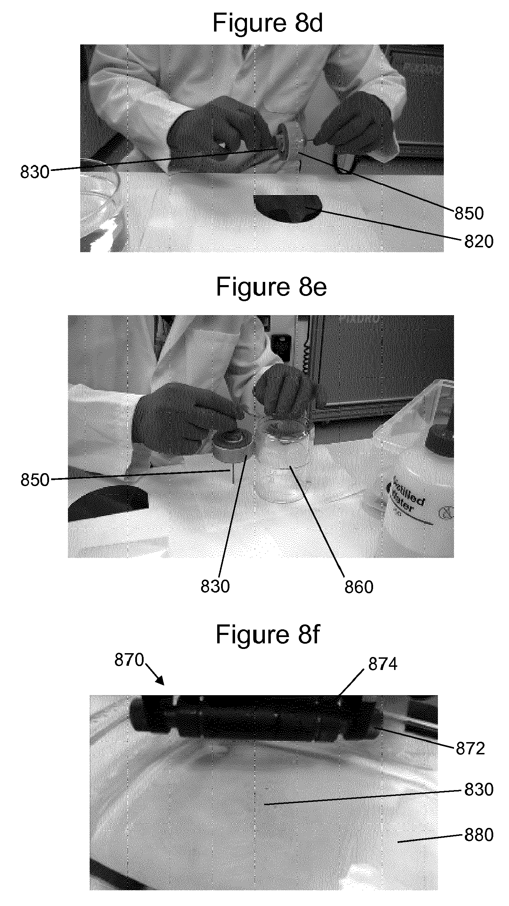

Figure 8d shows a textured surface present on the curved surface of a rotary manipulator 850 (a capillary net/mesh is wrapped around the curved surface to provide the textured surface as in figure 5). The graphene thin film 830 was present on the wafer 820. The rotary manipulator 850 is rolled over the graphene thin film 830 on the wafer 820 to pick it up from the wafer 820 and adhere it through capillary action to the wetted textured surface of the rotary manipulator 850 to the textured surface.

Figure 8e shows the graphene thin film 830 adhered to the textured surface of the rotary manipulator 850 and being transferred to a curved surface 860 (in this example to a poly(ethylene)naphthalate (PEN) layer attached to the curved surface 860 of a beaker). The rotary manipulator 850 was positioned so that its curved surface was in contact with the curved surface 860 of the beaker, and then rotated. The beaker 860 was also rotated in the opposite sense. In this way the graphene thin film 830 was transferred to the curved PEN-coated surface 860 of the beaker.

Figure 8f shows the pick-up of a graphene thin film 830 floating in a water bath 880 using a gravure-type roller 870 as discussed in relation to Figure 7. The roller 870 in this image is a two-roller stack (that is, an upper roller 874, only partially visible at the top of Figure 8f, and lower roller 872, have curved surfaces in contact with each other. The upper roller 874 is rotated, which causes the lower roller 872 to rotate in the opposite sense. This lower roller 872 has a textured curved surface with capillary bridges present, and as it rotates in contact with the floating graphene thin film 830 it picks up the graphene thin film 830. The upper roller 874 curved surface is coated with a PEN flexible substrate layer and the graphene thin film 830, once picked up on the lower roller 872, rotates to become in contact with the PEN surface of the upper roller 874. The graphene thin film 830 preferentially adheres to the PEN substrate of the upper roller 874 rather than the textured surface of the lower roller 872 and thus the graphene thin film 830 is transferred from the lower roller 872 to the upper roller 874.

Advantages of one or more of the methods discussed above include the ability to pick up and transfer thin films, which is a crucial step in automating the processing of thin film based manufacturing, such as the manufacture of graphene-based electronics. Using one or more methods described herein may allow for there to be less doping or residue remaining on the thin films after manipulation and lower damage on the graphene during transfer, which may otherwise occur using other thin film transfer methods. One or more processes described herein may be simpler and require fewer steps than other thin film pick-up and transfer methods. One or more methods described herein may allow for improved alignment of deposited thin films with a target substrate, due to the improved level of reproducibility and reliability of the pick-up and transfer process. One or more methods described herein may be beneficial for large area and automated thin film transfer, such as graphene sheet transfer.

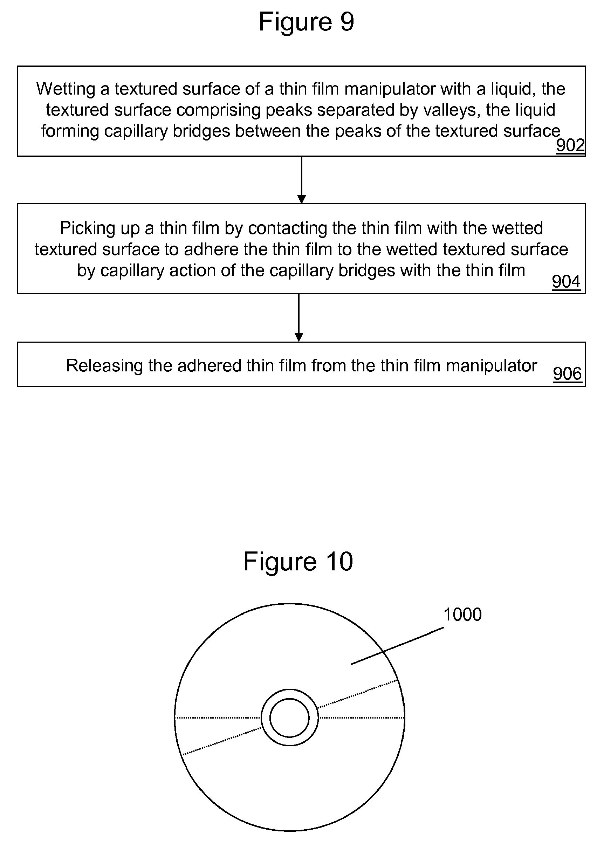

Figure 9 shows a thin film manipulation method according to examples described herein. The main steps of the method are: wetting a textured surface of a thin film manipulator with a liquid, the textured surface comprising peaks separated by valleys, the liquid forming capillary bridges between the peaks of the textured surface 902; picking up a thin film by contacting the thin film with the wetted textured surface to adhere the thin film to the wetted textured surface by capillary action of the capillary bridges with the thin film 904; and releasing the adhered thin film from the thin film manipulator 906. Other methods and ways of performing the above method steps are described above in relation to Figures 2 to Figures 8a-f.

Figure 10 shows a computer-readable medium 1000 comprising a computer program configured to perform, control or enable a method or one or more method steps described herein. The computer program may comprise computer code configured to perform, control or enable one or more of the method steps 902, 904, 906 of Figure 9. In this example, the computer/processor readable medium 1000 is a disc such as a digital versatile disc (DVD) or a compact disc (CD). In other examples, the computer/processor readable medium 1000 may be any medium that has been programmed in such a way as to carry out an inventive function. The computer/processor readable medium 1000 may be a removable memory device such as a memory stick or memory card (SD, mini SD, micro SD or nano SD).

Other examples depicted in the figures have been provided with reference numerals that correspond to similar features of earlier described examples. For example, feature number 1 can also correspond to numbers 101, 201, 301 etc. These numbered features may appear in the figures but may not have been directly referred to within the description of these particular examples. These have still been provided in the figures to aid understanding of the further examples, particularly in relation to the features of similar earlier described examples.

It will be appreciated that any "computer" described herein can comprise a collection of one or more individual processors/processing elements that may or may not be located on the same circuit board, or the same region/position of a circuit board or even the same device. In some examples one or more of any mentioned processors may be distributed over a plurality of devices. The same or different processor/processing elements may perform one or more functions described herein.

With reference to any discussion of any mentioned computer and/or processor and memory (e.g. including ROM, CD-ROM etc), these may comprise a computer processor, Application Specific Integrated Circuit (ASIC), field-programmable gate array (FPGA), and/or other hardware components that have been programmed in such a way to carry out the inventive function.

The applicant hereby discloses in isolation each individual feature described herein and any combination of two or more such features, to the extent that such features or combinations are capable of being carried out based on the present specification as a whole, in the light of the common general knowledge of a person skilled in the art, irrespective of whether such features or combinations of features solve any problems disclosed herein, and without limitation to the scope of the claims. The applicant indicates that the disclosed aspects/examples may consist of any such individual feature or combination of features. In view of the foregoing description it will be evident to a person skilled in the art that various modifications may be made within the scope of the disclosure.

While there have been shown and described and pointed out fundamental novel features as applied to different examples thereof, it will be understood that various omissions and substitutions and changes in the form and details of the devices and methods described may be made by those skilled in the art without departing from the spirit of the invention. For example, it is expressly intended that all combinations of those elements and/or method steps which perform substantially the same function in substantially the same way to achieve the same results are within the scope of the invention. Moreover, it should be recognized that structures and/or elements and/or method steps shown and/or described in connection with any disclosed form or example may be incorporated in any other disclosed or described or suggested form or example as a general matter of design choice. Furthermore, in the claims means-plus-function clauses are intended to cover the structures described herein as performing the recited function and not only structural equivalents, but also equivalent structures. Thus although a nail and a screw may not be structural equivalents in that a nail employs a cylindrical surface to secure wooden parts together, whereas a screw employs a helical surface, in the environment of fastening wooden parts, a nail and a screw may be equivalent structures.

## Claims

1. A thin film manipulation method comprising:
wetting a textured surface of a thin film manipulator with a liquid, the textured surface comprising peaks separated by valleys, the liquid forming capillary bridges between the peaks of the textured surface;
picking up a thin film by contacting the thin film with the wetted textured surface to adhere the thin film to the wetted textured surface by capillary action of the capillary bridges with the thin film; and
releasing the adhered thin film from the thin film manipulator.

2. The method of claim 1, wherein releasing the thin film comprises one or more of:
contacting the adhered thin film with a target substrate to adhere the thin film to the target substrate by substrate capillary action; the substrate capillary action being stronger than the capillary action of the capillary bridges acting to adhere the thin film to the wetted textured surface;
heating one or more of the liquid and the thin film manipulator;
applying a surfactant to the liquid;
drying the liquid;
evaporating the liquid;
illuminating the liquid with ultra violet light;
applying a fluid under pressure through the textured surface; and
stretching the textured surface.

3. The method of claim 1, wherein contacting the thin film with the wetted textured surface comprises tilting the wetted textured surface with respect to a length of the thin film to gradually contact and adhere the thin film to the wetted textured surface across the length of the thin film.

4. The method of claim 1, wherein the textured surface is a planar textured surface, and wherein contacting the thin film with the wetted textured surface comprises:
positioning an edge of the planar wetted textured surface at the thin film; and
tilting the planar wetted textured surface with respect to a length of the thin film to gradually contact and adhere the thin film to the planar wetted textured surface across the length of the thin film.

5. The method of claim 1, wherein the textured surface is curved, and wherein one or more of:
picking up the thin film comprises rolling the curved textured surface with respect to the thin film; and
releasing the thin film comprises rolling the curved surface with the thin film adhered thereto with respect to the target substrate.

6. The method of claim 1, wherein the textured surface is on a pick-up belt, and wherein picking up the thin film comprises rolling the pick-up belt with respect to the thin film.

7. The method of claim 1, wherein the textured surface is a thin film face of a porous belt, the porous belt having a porous structure with sufficient porosity to one or more of:
allow the formation of capillary bridges; and
allow the passage of a releasing fluid through the porous belt to facilitate release of the thin film adhered to the thin film face of the porous belt.

8. The method of claim 7, wherein:
picking up the thin film comprises contacting the thin film with a high porosity belt layer of a layered porous belt, the layered porous belt comprising the high porosity belt layer overlaying a low porosity belt layer, the low porosity belt layer configured to provide a barrier to releasing fluid used to break down the capillary bridges; the high porosity belt layer configured not to provide a barrier to releasing fluid used to break down the capillary bridges;
and wherein the method further comprises:
separating the overlaying high porosity belt layer from the low porosity belt layer to allow releasing fluid to be passed through the high porosity belt layer to the adhered thin film to facilitate release of the adhered thin film from the high porosity belt layer.

9. The method of claim 8, wherein the releasing fluid is a gas, and wherein the method further comprises providing a gas flow through the high porosity belt layer to the adhered thin film to facilitate release of the adhered thin film from the high porosity belt layer by the removal of capillary bridges.

10. The method of claim 1, wherein wetting the textured surface comprises:
wetting the textured surface with a liquid; and
partially drying the textured surface to leave capillary bridges formed between the peaks of the textured surface.

11. The method of claim 1, wherein the liquid wetting the textured surface comprises one or more of: water, organic solvent, alcohol, ethanol, isopropanol, methanol, aldehyde, ketone, aromatic solvent, toluene, *N*-Methylpyrrolidone, and fluorinated solvent.

12. The method of claim 1, wherein the textured surface comprises one or more of: a conductive layer, a non-conductive layer, a nanoporous layer, a polymeric layer, a stretchable layer, a flexible layer, a metallic layer, a ceramic layer, a non-woven textile layer, an embossed layer, a moulded layer, and a woven polymeric yarn network.

13. The textured surface may comprise one or more of:
a peak height range of between 1 µm and 5000µm;
a peak separation range of between 1 µm and 5000µm;
hemispherical, spherical, conical, rod-like, barrier-like and irregular peak shapes;
hemispherical, spherical, conical, cubic, cuboid-shaped, cylindrical, and irregular valley shapes.

14. A thin film manipulator comprising:
a textured surface comprising peaks separated by valleys which is wetted with a liquid, the liquid forming capillary bridges between the peaks of the textured surface; the wetted textured surface configured to
pick up a thin film by contacting the thin film with the wetted textured surface to adhere the thin film to the wetted textured surface by capillary action of the capillary bridges with the thin film; and
release the adhered thin film from the thin film manipulator.

15. A computer program comprising computer code configured to perform the method of any of claims 1-13.
